# EUROPEAN PATENT SPECIFICATION

(11) **EP 1 229 767 B1**
(45) Date of publication and mention of the grant of the patent: **20.01.2010**
(21) Application number: 02001990.7
(22) Date of filing: 05.02.2002
(51) Int. Cl.: H05K 1/02

(54) **Bus bar arrangement with an integrated printed circuit board**
Stromschienenanordnung mit einer inegrierten Leiterplatte
Conducteur de barres à bus avec une plaque de circuit imprimé, integré

(30) Priority: 05.02.2001 FR 0101743
(43) Date of publication of application: 07.08.2002
(73) Proprietor: IDEALEC, 25300 Pontarlier (FR)
(72) Inventor: Chevassus-More, Alain, 25370 Touillon et Loutelet (FR); Pernot, Christian, 25300 Pontarlier (FR)
(74) Representative: Palix, Stéphane

(56) References cited:
- EP-A- 0 929 123
- US-A- 3 818 119
- US-A- 5 875 101
- US-A- 6 083 047

## Description

The present invention relates to a bus bar arrangement according to the preamble of claim 1. Such a bus bar arrangement is already known from documents EP 0 929 123 A1 and US 3 818 199. Such arrangements are principally used in the field of strong currents. In this field, currents of some ten ampere can circulate at voltages of some hundred volt. Until now, these power circuits have been strictly separated from signal processing circuits, since in the latter case, currents of lesser voltages in view of order of magnitude are used, and it was feared that, according to circumstances, disturbing interactions between the strong current lines and the signal processing circuits might occur. Thus, since perfectly separated line systems for strong current and for signal processing had to be provided, cabling expenses were high.

Document EP 0 929 123 A1 describes a device in which the bus bars are molded integrally within a resin support and can be connected to electric circuits, the resin support being adapted to be fixed to or serve as a support for a printed circuit. This molding represents an operation which is complex and difficult to carry out.

It is the aim of the present invention to suppress these drawbacks and to propose a bus bar arrangement integrating the two circuits.

This aim is achieved by the bus bar arrangement according to claim 1.

According to a complementary embodiment, the bus bars have connection tabs on their front and/or longitudinal sides, which tabs are fixed onto the printed circuit board.

According to another complementary embodiment, the connection tabs are arranged on the edge of the printed circuit board.

According to another complementary embodiment, a protection is placed between the bus bars and the printed circuit board.

According to yet another complementary embodiment, the printed circuit board is situated between two bus bars.

It has become apparent that, when using a configuration of high intensity lines in flat conductive bands stacked one onto the other and comprising an insulation between them, these lines did not have an important disturbing influence on the immediately adjacent signal processing lines, but that, on the contrary and according to circumstances, they were even able to serve as a protection against outer perturbation sources. The present invention is based on the idea to arrange printed circuit boards by interposing insulating sheets in immediate contact with bus bars conceived as flat bands, and to assemble them within a laminate.

This leads to lesser space requirements and to a general simplification of cabling disposition in machine cabling or in other applications.

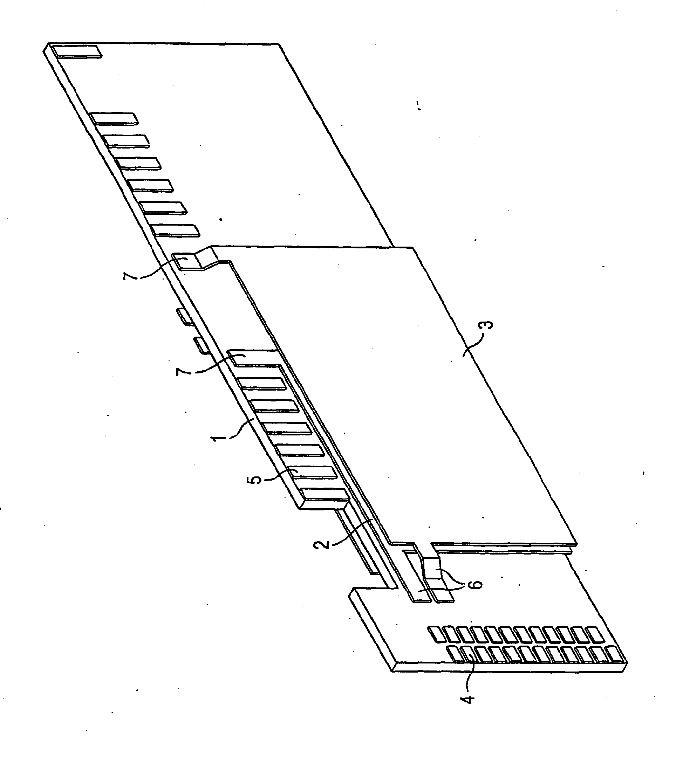

The present invention will be better understood by means of the description of an embodiment referring to the annexed unique figure.

This figure shows a perspective view of an embodiment of a bus bar.

On a printed circuit board (PCB) 1, two bus bars 2, 3 are interposed in layers with intermediate layers of insulating sheets (not shown). On its front side and on a longitudinal side, the printed circuit board 1 presents connection contact surfaces 4, 5 for impressing the printed circuit board into corresponding connectors of the edge of the printed circuit board. On their front or longitudinal sides, the bus bars 2, 3 also present connection tabs 6, 7 which are disposed such as to be also fixed to the edge of the printed circuit board. Thus, the connection tabs 6, 7 are situated within the disposition of the contacts 4, 5 of the printed circuit board 1 in such a way as to be brought into contact with the same connectors of the edge of the printed circuit board. Between the bus bars 2, 3 and the printed circuit board 1, a sheet with a protection (not shown) can be provided. The final dispositon of the printed circuit board and of the bus bars with intermediate insulating sheets is obtained by a laminating process. The insulating sheets may be made of polyamide (of the Nomex type), which permits to obtain the best temperature results. Other materials can also be used for the sheets, like for example PET (polyester terephthalate), PVC, PI (polyimide). Appropriate glues are used, depending on the chosen material. The bus bars are then composed of copper or copper alloy plates. As far as their thermal dilatation qualities are concerned, the components are chosen such that they can be implanted at operational temperatures between -40 and +130°C.

Preferably, the printed circuit board PCB is placed between two bus bars, thus avoiding the deformation of the laminated product, which deformation might arise due to differential dilatations between the layers.

The bus bar arrangement thus formed carries at the same time strong currents and integrated signal processing circuits, so that the expense in cabling is minimized compared to traditional solutions.

The present description of an example of embodiment should not be understood in a restrictive manner. On the contrary, the invention comprises all variants which are possible within the frame of the claims.

## Claims

1. Bus bar arrangement comprising at least two bus bars (2, 3), and at least one printed circuit board (PCB) (1), **characterized in that** the printed circuit board (1) is situated on one side or between the bus bars (2, 3), **in that** the complete arrangement is laminated, and **in that** electrical connections (6, 7) of the bus bars (2, 3) are integrated into the arrangement of the connections (4, 5) of the printed circuit board.

2. Bus bar arrangement according to claim 1, **characterized in that** the bus bars are stocked and insulated from each other by insulating sheets.

3. Bus bar arrangement according to any one of claims 1 to 2, **characterized in that** on their front and/or longitudinal sides, the bus bars have connection tabs (6, 7) which are fixed onto the printed circuit board.

4. Bus bar arrangement according to any one of claims 1 to 3, **characterized in that** the connection tabs (6, 7) of the bus bars (2, 3) are disposed on the edge of the printed circuit board.

5. Bus bar arrangement according to claim 4, **characterized in that** a protection is disposed between the bus bars (2, 3) and the printed circuit board (1).

6. Bus bar arrangement according to any one of the preceding claims, **characterized in that** the printed circuit board (1) is disposed between two bus bars.

7. Bus bar arrangement according to any one of the preceding claims, **characterized in that** the bus bars (2, 3) are made of copper or a copper alloy and that the insulation is composed of polyamide sheets.

8. Bus bar arrangement according to any one of the preceding claims, **characterized in that** there is no overlapping with the bus bars (2, 3) in the connection areas at the edges of the printed circuit board (1).

## Patentansprüche

1. Sammelschienenanordnung, die mindestens zwei Sammelschienen (2, 3) und mindestens eine gedruckte Leiterplatte (PCB) (1) aufweist, **dadurch gekennzeichnet, dass** die gedruckte Leiterplatte (1) sich auf einer Seite oder zwischen den Sammelschienen (2, 3) befindet, dass die komplette Anordnung laminiert ist, und dass elektrische Verbindungen (6, 7) der Sammelschienen (2, 3) in die Anordnung der Verbindungen (4, 5) der gedruckten Leiterplatte integriert sind.

2. Sammelschienenanordnung nach Anspruch 1, **dadurch gekennzeichnet, dass** die Sammelschienen durch Isolierfolien gelagert und durch diese von einander isoliert sind.

3. Sammelschienenanordnung nach einem der Ansprüche 1 bis 2, **dadurch gekennzeichnet, dass** die Sammelschienen an ihren Front- und/oder Längsseiten Anschlussfahnen (6, 7) haben, die an der gedruckten Leiterplatte befestigt sind.

4. Sammelschienenanordnung nach einem der Ansprüche 1 bis 3, **dadurch gekennzeichnet, dass** die Anschlussfahnen (6, 7) der Sammelschienen (2, 3) am Rand der gedruckten Leiterplatte angeordnet sind.

5. Sammelschienenanordnung nach Anspruch 4, **dadurch gekennzeichnet, dass** ein Schutz zwischen den Sammelschienen (2, 3) und der gedruckten Leiterplatte (1) angeordnet ist.

6. Sammelschienenanordnung nach einem der vorhergehenden Ansprüche, **dadurch gekennzeichnet, dass** die gedruckte Leiterplatte (1) zwischen zwei Sammelschienen angeordnet ist.

7. Sammelschienenanordnung nach einem der vorhergehenden Ansprüche, **dadurch gekennzeichnet, dass** die Sammelschienen (2, 3) aus Kupfer oder einer Kupferlegierung hergestellt sind, und dass die Isolierung aus Polyamidfolien besteht.

8. Sammelschienenanordnung nach einem der vorhergehenden Ansprüche, **dadurch gekennzeichnet, dass** es keine Überlappung mit den Sammelschienen (2, 3) in den Verbindungsbereichen an den Rändern der gedruckten Leiterplatte (1) gibt.

## Revendications

1. Agencement de barres omnibus comprenant au moins deux barres omnibus (2, 3), et au moins une carte de circuit imprimé (PCB) (1), **caractérisé en ce que** la carte de circuit imprimé (1) est située sur un premier côté ou entre les barres omnibus (2, 3), **en ce que** l'agencement complet est stratifié, et **en ce que** des connexions électriques (6, 7) des barres omnibus (2, 3) sont intégrées à l'agencement des connexions (4, 5) de la carte de circuit imprimé.

2. Agencement de barres omnibus selon la revendication 1, **caractérisé en ce que** les barres omnibus sont stockées et isolées les unes des autres par des feuilles isolantes.

3. Agencement de barres omnibus selon la revendication 1 ou 2, **caractérisé en ce que** sur leurs côtés avant et/ou longitudinal, les barres omnibus ont des pattes de connexion (6,7) qui sont fixées sur la carte de circuit imprimé.

4. Agencement de barres omnibus selon l'une quelconque des revendications 1 à 3, **caractérisé en ce que** les pattes de connexion (6, 7) des barres omnibus (2, 3) sont disposées sur le bord de la carte de circuit imprimé.

5. Agencement de barres omnibus selon la revendication 4, **caractérisé en ce qu'**une protection est disposée entre les barres omnibus (2, 3) et la carte de circuit imprimé (1).

6. Agencement de barres omnibus selon l'une quelconque des revendications précédentes, **caractérisé en ce que** la carte de circuit imprimé (1) est disposée entre deux barres omnibus.

7. Agencement de barres omnibus selon l'une quelconque des revendications précédentes, **caractérisé en ce que** les barres omnibus (2, 3) sont réalisées en cuivre ou en alliage de cuivre, et **en ce que** l'isolant est constitué de feuilles de polyamine.

8. Agencement de barres omnibus selon l'une quelconque des revendications précédentes, **caractérisé en ce qu'**il n'y a pas de chevauchement avec les barres omnibus (2, 3) dans les zones de connexion au niveau des bords de la carte de circuit imprimé (1).
